# EUROPÄISCHE PATENTSCHRIFT

(11) **EP 2 586 072 B1**
(45) Veröffentlichungstag und Bekanntmachung des Hinweises auf die Patenterteilung: **16.04.2014**
(21) Anmeldenummer: 11727968.7
(22) Anmeldetag: 22.06.2011
(51) Int. Cl.: H01L 41/047, F02M 51/06

(54) **PIEZOELEKTRISCHER AKTOR**
PIEZOELECTRIC ACTUATOR
ACTIONNEUR PIÉZOÉLECTRIQUE

(30) Priorität: 23.06.2010 DE 102010030432
(43) Veröffentlichungstag der Anmeldung: 01.05.2013
(73) Patentinhaber: Robert Bosch GmbH, 70442 Stuttgart (DE)
(72) Erfinder: KOCH, Thomas, 02943 Weißwasser (DE); SCHMIEDER, Dietmar, 71706 Markgröningen (DE); SEBASTIAN, Thomas, 71729 Erdmannhausen (DE); HARTMANN, Oliver, 91058 Erlangen (DE); KEGEL, Timo, 71665 Vaihingen (DE)
(86) Internationale Anmeldenummer: PCT/EP2011/060420
(87) Internationale Veröffentlichungsnummer: WO 2011/161144

(56) Entgegenhaltungen:
- WO-A1-00/79610
- WO-A1-2009/064990
- DE-A1- 19 928 191
- DE-A1-102004 015 574
- JP-A- 2002 289 934

## Beschreibung

### Stand der Technik

Die Erfindung betrifft einen piezoelektrischen Aktor für ein Brennstoffeinspritzventil und ein Brennstoffeinspritzventil mit solch einem piezoelektrischen Aktor. Speziell betrifft die Erfindung das Gebiet für Injektoren für Brennstoffeinspritzanlagen von Brennkraftmaschinen.

Aus der DE 199 28 189 A1 ist ein Piezoaktor bekannt, der zur Betätigung eines mechanischen Bauteils dient. Der Piezoaktor weist einen Mehrschichtaufbau von Piezolagen und dazwischen angeordneten Innenelektroden auf. Eine erste Außenelektrode ist hierbei auf eine leitende Fläche auf jeweils einer Seitenfläche angebracht, die mit den jeweiligen Innenelektroden kontaktiert ist. Eine elastische Kontaktierung zur Zuführung der elektrischen Spannung erfolgt über Anschlüsse an eine zweite netz- oder gewerbeartige Außenelektrode, die auf der ersten angeordnet ist. Die zweite Außenelektrode ist zumindest punktweise mit der ersten kontaktiert und weist ebenfalls im Bereich der Kontaktfläche oder der Kontaktpunkte dehnbare Bereiche auf.

Der aus der DE 199 28 189 A1 bekannte Piezoaktor hat den Nachteil, dass die Ausgestaltung der netz- oder gewerbeartigen Außenelektrode mit hohen Kosten verbunden ist. Hierbei ist es denkbar, dass als Außenelektrode auch eine siebförmige Außenelektrode zum Einsatz kommt. Solche Siebe sind allerdings durch die Maschinenausführung schlecht schweißbar und es ergeben sich aufwändige, unsicherere Schweißverbindungen mit den elektrischen Anschlusskabeln oder mit Kontaktblechen.

Die JP 2002-289934 A offenbart einen piezoelektrischen Vielschichtaktor mit einer Außenelektrode aus gewelltem Metallblech.

### Offenbarung der Erfindung

Der erfindungsgemäße piezoelektrische Aktor mit den Merkmalen des Anspruchs 1 und das erfindungsgemäße Brennstoffeinspritzventil mit den Merkmalen des Anspruchs 8 haben demgegenüber den Vorteil, dass eine kostengünstige Ausgestaltung zur Kontaktierung der

Elektrodenschichten des Aktorkörpers möglich ist und eine Herstellbarkeit verbessert ist. Speziell kann in einem vollautomatisierten Herstellungsprozess eine verbesserte und sichere Schweißverbindung mit elektrischen Anschlusskabeln, Kontaktblechen oder dergleichen ausgestaltet werden. Dabei weist das gewellte Blech eine Vielzahl von Wellen auf, so dass der Teil der Elektrodenschichten, der mit dem gewellten Blech elektrisch kontaktiert ist, mit dem Aktorkörper zugewandten Wellentälern der Wellen kontaktiert ist und die Wellen schräg zu einer Längsachse des Aktorkörpers ausgestaltet sind. Beispielsweise können die Wellentäler mit einem Winkel aus einem Bereich von etwa 5° bis etwa 20° schräg zu der Längsachse des Aktorkörpers ausgestaltet sein. Hierdurch ist eine gleichmäßige Verlötung der axial angeordneten Elektrodenschichten möglich. Hierdurch wird eine vorteilhafte und zuverlässige elektrische Kontaktierung der Elektrodenschichten gewährleistet.

Durch die in den Unteransprüchen aufgeführten Maßnahmen sind vorteilhafte Weiterbildungen des im Anspruch 1 angegebenen piezoelektrischen Aktors und des im Anspruch 8 angegebenen Brennstoffeinspritzventils möglich.

Das gewellte Blech ist zumindest im Wesentlichen aus zumindest einem Metall gebildet. Hierbei kann das gewellte Blech in vorteilhafter Weise aus einem lotplatierten Blech gebildet sein. Hierdurch kann ein zusätzliches Lotmaterial zum Ausbilden einer Lotverbindung mit den Elektrodenschichten eingespart werden. Zugleich kann durch die Ausgestaltung als gewelltes Metallblech eine hohe Stabilität gewährleistet werden und in vorteilhafter Weise eine Kontaktierung mit elektrischen Anschlusskabeln oder Kontaktblechen erfolgen. Die Verbindung des gewellten Metallblechs mit einem elektrischen Anschlusskabel oder einem Kontaktblech kann in vorteilhafter Weise als Schweißverbindung ausgestaltet sein. Speziell eignen sich elektrische Anschlusskabel für eine Dieselsystem-Ausführung, das heißt für luftverdichtende, selbstzündende Brennkraftmaschinen. Eine Kontaktierung mit Kontaktblechen eignet sich besonders für eine Benzin-Systemausführung, das heißt für gemischverdichtende, fremdgezündete Brennkraftmaschinen.

Ferner ist es vorteilhaft, dass das gewellte Blech aus einem beschichteten Federstahl oder aus Kupfer oder aus einer Legierung aus Kupfer und Zinn oder aus einer Invarlegierung gebildet ist. Hierdurch ergeben sich vorteilhafte Eigenschaften, die eine zuverlässige Kontaktierung mit den Elektrodenschichten, eine zuverlässige Kontaktierung mit elektrischen Anschlusskabeln, Kontaktblechen oder dergleichen und eine einfache Herstellung ermöglichen, wobei außerdem eine medienbeständige Ausgestaltung gegeben ist und ein vorteilhaftes Dehnungsverhalten bei Temperaturänderungen sowie eine ausreichende Elastizität gewährleistet sind. Ferner kann eine vorteilhafte Herstellung der gewellten Metallbleche durch Stanzen und Biegen erfolgen. Solch ein gewelltes Metallblech ist dann als Stanz-Biegeteil ausgestaltet. Eine Breite des gewellten Metallblechs ist je nach vorgesehener Strombelastung vorgegeben. Beispielsweise kann eine Breite aus einem Bereich von etwa 2 mm bis etwa 3 mm gewählt sein. Die gewählte Breite hängt hierbei auch von einer Stärke des gewellten Blechs ab.

In vorteilhafter Weise ist das gewellte Blech möglichst dünnwandig ausgestaltet. Hierbei ist es vorteilhaft, dass das gewellte Blech eine Materialstärke aus einem Bereich von etwa 0,1 mm bis etwa 0,3 mm aufweist. Hierdurch kann gewährleistet werden, dass das gewellte Blech einerseits zum Hubausgleich des Aktors in axialer Richtung möglichst flexibel ist und dass andererseits eine ausreichende Belastbarkeit hinsichtlich mechanischer Einwirkungen und elektrischer Strombelastung gewährleistet ist.

Somit kann in vorteilhafter Weise das gewelltes Blech anstelle eines Siebs oder dergleichen zur elektrischen Kontaktierung der Elektrodenschichten des Aktorkörpers dienen. Das gewellte Blech wird hierbei mit dem Aktorkörper verlötet. In vorteilhafter Weise werden zwei gewellte Bleche an den Aktorkörper angebracht, die die beiden Außenelektroden bilden, die abwechselnd mit den Elektrodenschichten des Aktorkörpers elektrisch kontaktiert, insbesondere verlötet, sind.

In vorteilhafter Weise ist der Teil der Elektrodenschichten, der mit dem gewellten Blech elektrisch kontaktiert ist, hierbei durch eine Lötverbindung mit den Wellentälern elektrisch verbunden.

Die elektrischen Anschlusselemente, die in Form von Anschlusskabeln, Kontaktblechen oder dergleichen ausgestaltet sein können, können in vorteilhafter Weise durch Widerstandsschweißen mit den gewellten Metallblechen verbunden sein.

### Kurze Beschreibung der Zeichnungen

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigt:
Fig. 1 einen piezoelektrischen Aktor in einer schematischen Darstellung entsprechend einem Ausführungsbeispiel der Erfindung und
Fig. 2 den in Fig. 1 dargestellten piezoelektrischen Aktor aus der mit II bezeichneten Blickrichtung in einer teilweise geschnittenen Darstellung.

### Ausführungsformen der Erfindung

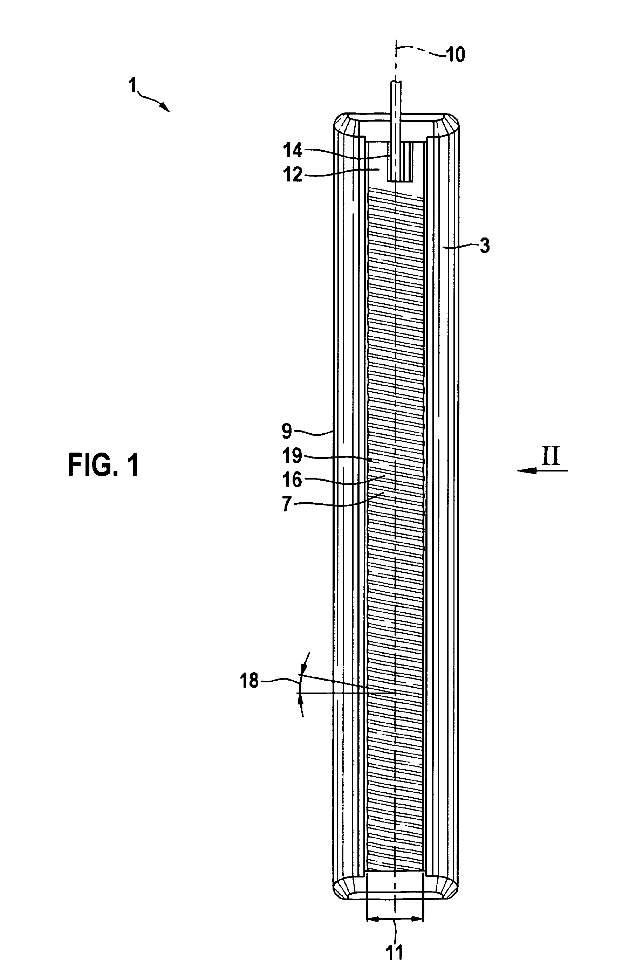

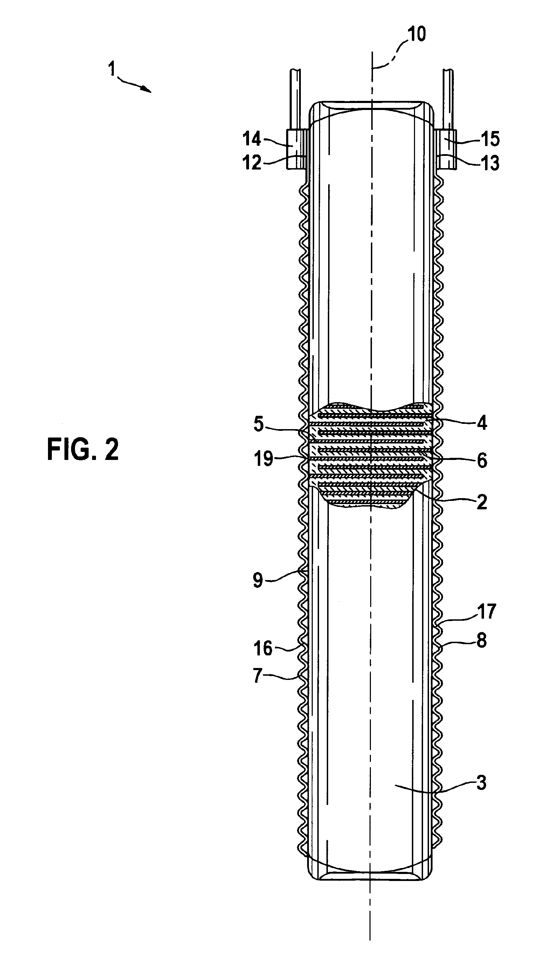

Fig. 1 zeigt einen piezoelektrischen Aktor 1 in einer schematischen Darstellung entsprechend einem Ausführungsbeispiel der Erfindung. Fig. 2 zeigt den in Fig. 1 dargestellten piezoelektrischen Aktor 1 des Ausführungsbeispiels der Erfindung aus der mit II bezeichneten Blickrichtung, wobei der Aktor 1 in einem Bereich 2 in einer axialen Schnittdarstellung dargestellt ist. Der piezoelektrische Aktor 1 kann insbesondere als Aktor 1 für Brennstoffeinspritzventile ausgestaltet sein. Hierbei eignet sich der Aktor 1 sowohl für Brennstoffeinspritzanlagen von luftverdichtenden, selbstzündenden Brennkraftmaschinen als auch für Brennstoffeinspritzanlagen von gemischverdichtenden, fremdgezündeten Brennkraftmaschinen. Der erfindungsgemäße piezoelektrische Aktor 1 eignet sich jedoch auch für andere Anwendungsfälle.

Der piezoelektrische Aktor 1 weist einen Aktorkörper 3 auf, der eine Vielzahl von keramischen Schichten 4 und eine Vielzahl von zwischen den keramischen Schichen 4 angeordneten Elektrodenschichten 5, 6 aufweist. Hierbei sind zur Vereinfachung der Darstellung in der Fig. 2 nur die Elektrodenschichten 5, 6 gekennzeichnet. Außerdem weist der piezoelektrische Aktor 1 Außenelektroden 7, 8 auf. Ein Teil der Elektrodenschichten, insbesondere die Elektrodenschicht 5, ist mit der Außenelektrode 7 verbunden. Ein anderer Teil der Elektrodenschichten, insbesondere die Elektrodenschicht 6, ist mit der Außenelektrode 8 verbunden. Hierbei sind die Elektrodenschichten 5, 6 abwechselnd mit den Außenelektroden 7, 8 verbunden. Hierfür ist der eine Teil der Elektrodenschichten, insbesondere die Elektrodenschicht 5, im Bereich der Außenelektrode 7 bis an eine Außenseite 9 des Aktorkörpers 3 geführt, während dieser im Bereich der Außenelektrode 8 von der Außenseite 9 beabstandet ist. Entsprechend ist der andere Teil der Elektrodenschichten, der die Elektrodenschicht 6 umfasst, im Bereich der Außenelektrode 7 von der Außenseite 9 beabstandet und im Bereich der Außenelektrode 8 bis an die Außenseite 9 geführt.

Die Außenelektroden 7, 8 sind jeweils aus einem gewellten Blech 7, 8 gebildet. In diesem Ausführungsbeispiel sind die Außenelektroden 7, 8 aus gewellten Metallblechen 7, 8 gebildet. Als Werkstoff für die Metallbleche 7, 8 kann ein beschichteter Federstahl, Kupfer, eine Legierung aus Kupfer und Zinn, eine Invarlegierung oder dergleichen dienen. Außerdem kann als Material zur Ausgestaltung der gewellten Metallbleche 7, 8 auch ein lotplatiertes Material zum Einsatz kommen. Dies hat den Vorteil, dass beim Verbinden der Elektrodenschichten 5, 6 mit den Außenelektroden 7, 8 kein zusätzliches Lotmaterial für die Lötung erforderlich ist. Dadurch kann die Herstellung vereinfacht werden. Außerdem können die gewellten Metallbleche 7, 8 als gestanzte und gebogene Bleche 7, 8 ausgestaltet werden. Die gewellten Metallbleche 7, 8 sind dann als Stanz-Biegeteile ausgeführt.

Die Außenelektroden 7, 8 sind an die Außenseite 9 des Aktorkörpers 3 angebracht und durch Lötverbindungen mit dem Aktorkörper 3 verbunden. Hierbei sind die Außenelektroden 7, 8 so an die Außenseite 9 angebracht, dass sich diese entlang einer Längsachse 10 des Aktorkörpers 3 erstrecken. Eine Breite 11 der Außenelektroden 7, 8 ist hierbei so vorgegeben, dass eine ausreichende Belastbarkeit insbesondere in Bezug auf die auftretende Strombelastung gegeben ist. Beispielsweise kann die Breite 11 aus einem Bereich von etwa 2 mm bis etwa 3 mm gewählt sein. Eine Stärke der gewellten Metallbleche 7, 8 ist möglichst dünnwandig vorgegeben, um eine hohe Flexibilität und Verformbarkeit zu ermöglichen. Hierbei sind die Blechstärken allerdings ausreichend groß gewählt, um den Anforderungen in Bezug auf die mechanische Belastung und die Strombelastung zu entsprechen. Beispielsweise können Blechstärken aus einem Bereich von etwa 0,1 mm bis etwa 0,3 mm zum Einsatz kommen.

Die Bleche 7, 8 weisen Anschlusszonen 12, 13 auf, an denen Anschlusselemente 14, 15 angebracht sind. Die Verbindung der Anschlusselemente 14, 15 mit den Anschlusszonen 12, 13 der Bleche 7, 8 kann beispielsweise durch Widerstandsschweißen ausgestaltet sein. Hierdurch ist eine zuverlässige mechanische und elektrische Verbindung gewährleistet. Speziell können als Anschlusselemente 14, 15 elektrische Anschlusskabel oder Kontaktbleche dienen.

Die gewellten Metallbleche 7, 8 weisen eine Vielzahl von Wellen 16, 17 auf, von denen nur die Wellen 16, 17 gekennzeichnet sind. Hierbei sind die Wellen 16, 17 schräg zu der Längsachse 10 angeordnet. Beispielsweise können die Wellen 16, 17 mit einem Winkel 18 aus einem Bereich von etwa 5° bis etwa 20° schräg zu der Längsachse 10 des Aktorkörpers 3 ausgestaltet sein. Ein Winkel 18 von 0° würde bedeuten, dass jede einzelne der Wellen 16, 17 senkrecht zu der Längsachse 10 angeordnet wäre. Durch die schräge Anordnung der Wellen 16, 17 wird allerdings eine Kontaktierung mit den einzelnen Elektrodenschichten 7, 8 im Bereich der Außenseite 9 verbessert. Hierbei sind einzelne Wellen 16, 17 der Metallbleche 7, 8 in diesem Ausführungsbeispiel mit mehreren Elektrodenschichten durch das Lotmaterial verbunden.

Beispielsweise weist das gewellte Metallblech 7 ein der Außenseite 9 zugewandtes Wellental 19 auf. Das Wellental 19 ist hierbei mit der Elektrodenschicht 5 verbunden. Durch die schräge Ausgestaltung ist das Wellental 19 auch mit weiteren Elektroden verbunden, die im Bereich des Metallblechs 7 an die Außenseite 9 geführt sind.

Somit kann in zuverlässiger Weise eine elektrische Kontaktierung aller Elektrodenschichten einerseits durch die Außenelektrode 7 und andererseits durch die Außenelektrode 8 gewährleistet werden.

Die Erfindung ist nicht auf die beschriebenen Ausführungsbeispiele beschränkt.

## Patentansprüche

1. Piezoelektrischer Aktor (1), insbesondere Aktor für Brennstoffeinspritzventile, mit einem Aktorkörper (3), der eine Vielzahl von keramischen Schichten (4) und eine Vielzahl von zwischen den keramischen Schichten angeordneten Elektrodenschichten (5, 6) aufweist, und zumindest einer Außenelektrode (7, 8), die mit einem Teil der Elektrodenschichten (5, 6) elektrisch kontaktiert ist, wobei die Außenelektroden (7, 8) zumindest teilweise aus zumindest einem gewellten Metallblech (7, 8) mit einer Vielzahl von Wellen (16, 17) gebildet ist und der Teil der Elektrodenschichten (5, 6), der mit dem gewellten Blech (7, 8) elektrisch kontaktiert ist, mit dem Aktorkörper (3) zugewandten Wellentälern (19) der Wellen (16, 17) kontaktiert ist, **dadurch gekennzeichnet, dass** die Wellen (16, 17) schräg zu einer Längsachse (10) des Aktorkörpers (3) ausgestaltet sind.

2. Piezoelektrischer Aktor nach Anspruch 1,
**dadurch gekennzeichnet,**
**dass** das gewellte Blech (7, 8) zumindest im Wesentlichen aus einem beschichteten Federstahl gebildet ist oder dass das gewellte Blech (7, 8) aus einem Werkstoff gebildet ist, der zumindest im Wesentlichen auf Kupfer oder zumindest im Wesentlichen auf einer Legierung aus Kupfer und Zinn oder zumindest im Wesentlichen auf einer Invarlegierung basiert.

3. Piezoelektrischer Aktor nach einem der Ansprüche 1 bis 2,
**dadurch gekennzeichnet,**
**dass** das gewellte Blech (7, 8) aus einem lotplatierten Blech (7, 8) gebildet ist.

4. Piezoelektrischer Aktor nach einem der Ansprüche 1 bis 3,
**dadurch gekennzeichnet,**
**dass** das gewellte Blech (7, 8) eine Materialstärke aus einem Bereich von etwa 0,1 mm bis etwa 0,3 mm aufweist.

5. Piezoelektrischer Aktor nach Anspruch 1,
**dadurch gekennzeichnet,**
**dass** die Wellen mit einem Winkel (18) aus einem Bereich von etwa 5° bis etwa 20° schräg zu der Längsachse (10) des Aktorkörpers (3) ausgestaltet sind.

6. Piezoelektrischer Aktor nach Anspruch 1 oder 5,
**dadurch gekennzeichnet,**
**dass** der Teil der Elektrodenschichten (5, 6), der mit dem gewellten Blech (7, 8) elektrisch kontaktiert ist, durch eine Lotverbindung mit den Wellentälern (19) elektrisch verbunden ist.

7. Piezoelektrischer Aktor nach einem der Ansprüche 1 bis 6,
**dadurch gekennzeichnet,**
**dass** ein elektrisches Anschlusselement (14, 15) vorgesehen ist, das durch eine Schweißverbindung mit dem gewellten Blech (7, 8) verbunden ist.

8. Brennstoffeinspritzventil, insbesondere Injektor für Brennstoffeinspritzanlagen von Brennkraftmaschinen, mit einem piezoelektrischen Aktor (1) nach einem der Ansprüche 1 bis 7.

## Claims

1. Piezoelectric actuator (1), in particular an actuator for fuel injection valves, with an actuator body (3), which has a multiplicity of ceramic layers (4) and a multiplicity of electrode layers (5, 6) arranged between the ceramic layers, and at least one outer electrode (7, 8), which is in electrical contact with some of the electrode layers (5, 6), the outer electrode (7, 8) being formed at least partially by at least one corrugated metal sheet (7, 8) with a multiplicity of corrugations (16, 17), and those of the electrode layers (5, 6) that are in electrical contact with the corrugated sheet (7, 8) being in contact with troughs (19) of the corrugations (16, 17) that are facing the actuator body (3), **characterized in that** the corrugations (16, 17) are formed obliquely in relation to a longitudinal axis (10) of the actuator body (3).

2. Piezoelectric actuator according to Claim 1, **characterized in that** the corrugated sheet (7, 8) is formed at least substantially from a coated spring steel or **in that** the corrugated sheet (7, 8) is formed from a material that is based at least substantially on copper or at least substantially on an alloy of copper and tin or at least substantially on an invar alloy.

3. Piezoelectric actuator according to either of Claims 1 and 2, **characterized in that** the corrugated sheet (7, 8) is formed from a solder-plated sheet (7, 8).

4. Piezoelectric actuator according to one of Claims 1 to 3, **characterized in that** the corrugated sheet (7, 8) has a material thickness from a range of approximately 0.1 mm to approximately 0.3 mm.

5. Piezoelectric actuator according to Claim 1, **characterized in that** the corrugations are formed obliquely in relation to the longitudinal axis (10) of the actuator body (3) with an angle (18) from a range of approximately 5° to approximately 20°.

6. Piezoelectric actuator according to Claim 1 or 5, **characterized in that** those of the electrode layers (5, 6) that are in electrical contact with the corrugated sheet (7, 8) are electrically connected to the troughs (19) of the corrugations by a soldered connection.

7. Piezoelectric actuator according to one of Claims 1 to 6, **characterized in that** an electrical connection element (14, 15) is provided, connected to the corrugated sheet (7, 8) by a welded connection.

8. Fuel injection valve, in particular an injector for fuel injection systems of internal combustion engines, with a piezoelectric actuator (1) according to one of Claims 1 to 7.

## Revendications

1. Actionneur piézoélectrique (1), en particulier actionneur pour soupapes d'injection de carburant, comprenant un corps d'actionneur (3) qui présente une pluralité de couches céramiques (4) et une pluralité de couches d'électrodes (5, 6) disposées entre les couches céramiques, et au moins une électrode extérieure (7, 8) avec laquelle vient en contact électrique une partie des couches d'électrodes (5, 6), l'électrode extérieure (7, 8) étant formée au moins en partie d'au moins une tôle métallique (7, 8) avec une pluralité d'ondulations (16, 17) et la partie des couches d'électrodes (5, 6) qui vient en contact électrique avec la tôle ondulée (7, 8) venant en contact avec des vallées d'ondulations (19), tournées vers le corps d'actionneur (3), des ondulations (16, 17), **caractérisé en ce que** les ondulations (16, 17) sont configurées obliquement par rapport à un axe longitudinal (10) du corps d'actionneur (3).

2. Actionneur piézoélectrique selon la revendication 1, **caractérisé en ce que** la tôle ondulée (7, 8) est formée au moins essentiellement d'un acier à ressort revêtu ou **en ce que** la tôle ondulée (7, 8) est formée d'un matériau au moins essentiellement à base de cuivre ou au moins essentiellement à base d'un alliage de cuivre et d'étain ou au moins essentiellement à base d'un alliage d'invar.

3. Actionneur piézoélectrique selon l'une quelconque des revendications 1 à 2, **caractérisé en ce que** la tôle ondulée (7, 8) est formée d'une tôle plaquée par brasage (7, 8).

4. Actionneur piézoélectrique selon l'une quelconque des revendications 1 à 3, **caractérisé en ce que** la tôle ondulée (7, 8) présente une épaisseur de matériau dans une plage d'environ 0,1 mm à environ 0,3 mm.

5. Actionneur piézoélectrique selon la revendication 1, **caractérisé en ce que** les ondulations sont configurées avec un angle (18) dans une plage d'environ 5° à environ 20° obliquement par rapport à l'axe longitudinal (10) du corps d'actionneur (3).

6. Actionneur piézoélectrique selon la revendication 1 ou 5, **caractérisé en ce que** la partie des couches d'électrodes (5, 6) qui vient en contact électrique avec la tôle ondulée (7, 8) est connectée électriquement par une connexion par brasage aux vallées d'ondulations (19).

7. Actionneur piézoélectrique selon l'une quelconque des revendications 1 à 6, **caractérisé en ce qu'**un élément de raccordement électrique (14, 15) est prévu, lequel est connecté par une connexion soudée à la tôle ondulée (7, 8).

8. Soupape d'injection de carburant, en particulier injecteur pour installations d'injection de carburant de moteurs à combustion interne, comprenant un actionneur piézoélectrique (1) selon l'une quelconque des revendications 1 à 7.
